# EUROPÄISCHE PATENTSCHRIFT

(11) **EP 0 906 718 B1**
(45) Veröffentlichungstag und Bekanntmachung des Hinweises auf die Patenterteilung: **11.10.2000**
(21) Anmeldenummer: 97930332.8
(22) Anmeldetag: 17.06.1997
(51) Int. Cl.: H05K 7/14

(54) **BAUGRUPPENTRÄGER FÜR EINSTECKBARE ELEKTRISCHE FLACHBAUGRUPPEN MIT MITTELN ZUR GEDÄMPFTEN ABLEITUNG ELEKTROSTATISCHER POTENTIALE**
SUB-RACK FOR PLUG-IN PRINTED CIRCUIT MODULES WITH A MEANS OF DAMPED DISCHARGE OF ELECTROSTATIC POTENTIAL
BATI POUR CARTES A CIRCUITS IMPRIMES ENFICHABLES AVEC MOYENS POUR LA DECHARGE AMORTIE DE POTENTIELS ELECTROSTATIQUES

(30) Priorität: 18.06.1996 DE 29610694 U
(43) Veröffentlichungstag der Anmeldung: 07.04.1999
(73) Patentinhaber: SIEMENS AKTIENGESELLSCHAFT, 80333 München (DE)
(72) Erfinder: BILLENSTEIN, Ernst, D-91593 Burgbernheim (DE); KÖRBER, Werner, D-91282 Betzenstein (DE); KURRER, Siegfried, D-90449 Nürnberg (DE); SCHAFFER, Kurt-Michael, D-90542 Eckental (DE)
(86) Internationale Anmeldenummer: DE9701234
(87) Internationale Veröffentlichungsnummer: WO9749271

(56) Entgegenhaltungen:
- WO-A-90/03101
- WO-A-95/10932
- DE-A- 2 743 194
- DE-A- 3 624 883

## Beschreibung

Es kann das Problem auftreten, daß beim Einstecken einer elektrischen Flachbaugruppe in einen Baugruppenträger durch äußere elektrostatische Spannungen und statische Spannungspotentiale Störungen im Inneren des Baugruppenträgers, und dabei insbesondere bei bereits eingesteckten, anderen Flachbaugruppen, verursacht werden können. Dabei wird eine elektrostatische Spannung beim Einsteckvorgang insbesondere von einer Person zunächst auf eine elektrisch leitende, insbesondere metallische Frontplatte der einzusteckenden Flachbaugruppe übertragen. Die in der Regel sehr hohe elektrostatische Spannung kann dann durch Entladungsvorgänge, wie beispielsweise durch eine Funkenstrecke erzeugte hochfrequente Signale, oder durch eine Potentialanhebung eine Störung von elektrischen Bauelementen auf der Flachbaugruppe selbst oder auf benachbarten Flachbaugruppen verursachen. Dies ist insbesondere dann unerwünscht, wenn Flachbaugruppen während des Betriebs weiterer Flachbaugruppen im Baugruppenträger ein- bzw. aussteckbar sein sollen. Das Ein- bzw. Ausstecken einer Flachbaugruppe während des Betriebs der übrigen Flachbaugruppen wird als sogenannte "Life-Insertion" bezeichnet.

In Figur la ist der untere Bereich einer bekannten Gestaltungsform eines Baugruppenträgers BGT ausschnittsweise in einem Seitenschnitt dargestellt. Dabei ist beispielsweise eine elektrische Flachbaugruppe BG wiederum ausschnittsweise dargestellt Diese weist zumindest auf eine Leiterplatte LP, an der an der Frontseite eine elektrisch leitende, insbesondere metallische Frontplatte FP und an der Rückseite ein Steckverbinder V2 angebracht ist. Ferner ist ein sich entlang des unteren Randbereiches der Leiterplatte LP erstreckender streifenförmiger Schleifkontakt K vorhanden. Dieser Schleifkontakt K ist elektrisch leitend mit der Frontplatte FP der Flachbaugruppe BG verbunden. Zum Einstecken der Flachbaugruppe BG in Einsteckrichtung ER ist zumindest eine untere Führungsschiene LS des Baugruppenträgers BGT vorhanden, welche zwischen einer vorderen und einer hinteren Querschiene QV, QH angebracht ist. Zumindest ein Kontaktfederelement F1 ist im vorderen Bereich im Innern des Baugruppenträgers BGT angeordnet und elektrisch leitend bevorzugt über die darunter liegende vordere Querschiene QV mit diesem verbunden. Vorteilhaft ist das Kontaktfederelement in die Führungsschiene integriert. Eine mögliche Ausführung für eine derartige Integration ist der deutschen Patentschrift DE 3 624 883 C2 zu entnehmen. Bei einem Einschub der Flachbaugruppe BG kontaktiert das Kontaktfederelement F1 den Schleifkontakt K bereits zu Beginn des Einschubvorgangs, so daß eine elektrisch leitende Verbindung zwischen der Frontplatte FP und dem in der Regel auf Spannungsnullpotential liegenden Baugruppenträger BGT bewirkt wird.

Nachteilig ist es, daß mögliche, auf der Frontplatte FP gespeicherte, äußere elektrostatische Spannungen bei Einschub der Flachbaugruppe BG in den Baugruppenträger BGT bei Kontaktschluß zwischen Schleifkontakt K und Kontaktfederelement F1 eine Funkenstrecke im Innern des Baugruppenträgers BGT erzeugen können. Eine derartige Funkenstrecke bewirkt hochfrequente Störsignale, welche beispielsweise die Funktion von benachbarten, in den Baugruppenträger BGT bereits eingeschobenen Flachbaugruppen stören können.

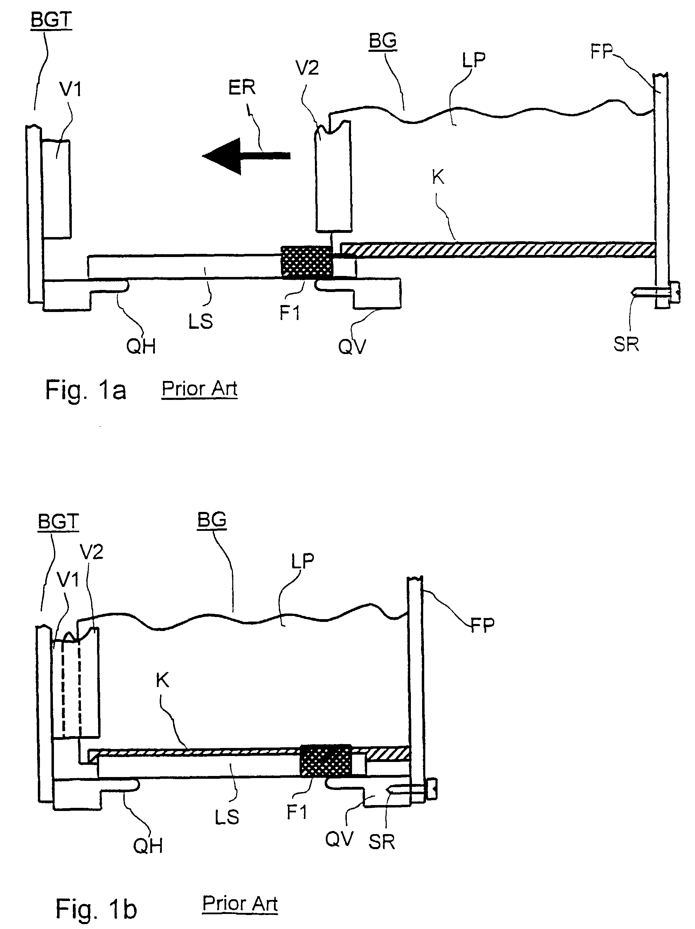

In Figur 1b ist der bereits in der Figur 1a dargestellte Baugruppenträger BGT mit der Flachbaugruppe BG im eingesteckten Zustand dargestellt. Der Steckverbinder V2 an der Rückseite der Flachbaugruppe BG ist nun kontaktierend in einen korrespondierenden Steckverbinder V1 eingesteckt, welcher im Inneren des Baugruppenträgers bevorzugt auf einer sogenannten Rückwandleiterplatte angebracht ist. Von außen auf die Frontplatte FP aufgebrachte Potentiale, wie beispielsweise eine durch Berührung aufgebrachte elektrostatische Spannung, fließen über den Schleifkontakt K, das Kontaktfederelement F1 und die Querschiene QV auf den in der Regel geerdeten Baugruppenträger BGT ab. Ein Problem stellen Störungen dar, die dabei möglicherweise über den "antennenartigen", streifenförmigen Schleifkontakt K bis tief ins Innere des Baugruppenträgers BGT "ausgestrahlt" werden und somit die Funktion von Flachbaugruppen im Baugruppenträger BGT ebenfalls stören können.

Schließlich ist in aller Regel zumindest eine Kontaktschraube SR am unteren Ende der Frontplatte FP angebracht. Diese wird nach dem vollständigen Einschub der Flachbaugruppe BG z.B. mit der unteren Querschiene QV verschraubt, und hat dann die Funktion einer Schutzkontaktes, welcher eine ausreichende Stromtragefähigkeit aufweist.

Aufgabe der Erfindung ist es, elektrostatische Ladungen auf Flachbaugruppen derart an den Baugruppenträger abzuleiten, daß eine störungsfreie Funktion von bereits im Baugruppenträger eingesteckten und in Betrieb befindlichen weiteren Flachbaugruppen gewährleistet wird.

Die Aufgabe wird gelöst mit dem im Anspruch 1 angegebenen Baugruppenträger. Weitere, vorteilhafte Ausführungsformen sind in den Unteransprüchen enthalten.

Vorteil des erfindungsgemäßen Baugruppenträgers ist die durch einen elektrischen Widerstand gedämpfte, nicht kurzschlußartige Ableitung mit einer definierbaren Zeitkonstante von auf die Frontplatte aufgebrachten elektrostatischen Ladungen an den Baugruppenträger. Vergleichbar mit einem Widerstands-Kondensator-Schaltkreis, fließen elektrische Ladungen von der Frontplatte der Flachbaugruppe, welche die Funktion eines Kondensators aufweist, über den Widerstand gedämpft ab. Eine Funkenbildung zwischen Schleifkontakt und Kontaktfederelement beim Einschub der Flachbaugruppe in den Baugruppenträger wird dadurch erfindungsgemäß verhindert. Folglich sind vorteilhaft keine durch Überschläge verursachten Störsignale im Baugruppenträger zu befürchten.

Ein weiterer Vorteil stellen bei einer Ausführungsform gegebenenfalls zusätzlich vorhandene weitere Federelemente im Innern des Baugruppenträgers dar. Dadurch ist erfindungsgemäß ein Schleifkontakt der Flachbaugruppe auch im hinteren Bereich des Baugruppenträgers mit diesem kontaktierbar. Die mögliche "Antennenwirkung" des Schleifkontaktes wird dadurch auch im eingesteckten Zustand der Flachbaugruppe bei von außen auf die Frontplatte aufgebrachten Störungen verhindert.

Weitere vorteilhafte Ausführungsformen der Erfindung sind in den entsprechenden Unteransprüchen angegeben.

Die Erfindung wird desweiteren anhand eines in den nachfolgend kurz angeführten Figuren dargestellten Ausführungsbeispieles weiter erläutert. Dabei zeigt
- FIG 1a: beispielhaft eine Seitenansicht des bereits erläuterten Ausführungsform eines bekannten Baugruppenträgers,
- FIG 1b: beispielhaft die Seitenansicht des bereits erläuterten und in Figur 1a dargestellten bekannten Baugruppenträgers mit vollständig eingeschobener Flachbaugruppe,
- FIG 2a: die Seitenansicht eines Ausführungsbeispiels eines erfindungsgemäßen Baugruppenträgers mit einem Widerstand zwischen dem Schleifkontakt und der Frontplatte einer Flachbaugruppe,
- FIG 2b: die Seitenansicht des in Figur 2a dargestellten Baugruppenträgers mit vollständig eingeschobener Flachbaugruppe,
- FIG 3a: die Seitenansicht einer weiteren Ausführung des erfindungsgemäßen Baugruppenträgers mit einem zusätzlichen Kontaktstift an Innenseite der Frontplatte, und
- FIG 3b: die Seitenansicht des in Figur 3a dargestellten Baugruppenträgers mit vollständig eingeschobener Flachbaugruppe.

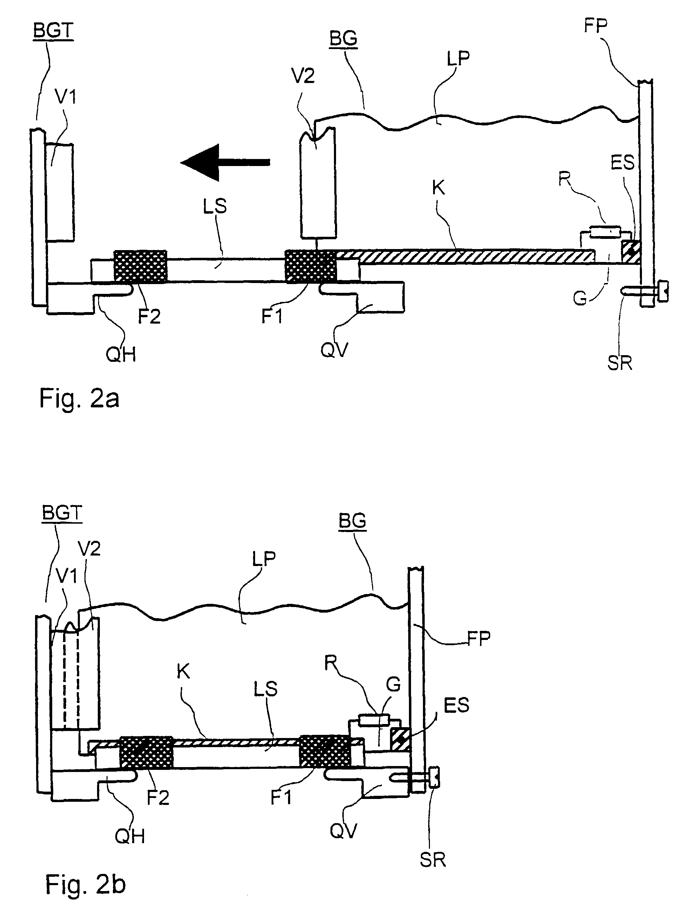

In Figur 2a ist beispielhaft eine Seitenansicht eines Baugruppenträgers BGT gemäß der Erfindung mit einer in diesen einschiebbaren elektrischen Flachbaugruppe BG dargestellt. Diese weist eine elektrisch leitende, bevorzugt metallische Frontplatte FP und eine Leiterplatte LP auf. Zum Einschieben der Flachbaugruppe BG in den Baugruppenträger BGT sind in diesem vorteilhaft zumindest eine untere Führungsschiene LS angebracht, welche zur Aufnahme und Führung der Leiterplatte LP über deren Kante dient. Insbesondere durch mehrere nebeneinander in den Baugruppenträger BGT einführbare Flachbaugruppen BG wird mittels der jeweiligen Frontplatten FP eine elektromagnetisch abschirmende Frontseite des Baugruppenträgers BGT gebildet. Die Leiterplatte LP weist dabei an den Randbereichen mindestens einen streifenförmigen Schleifkontakt K auf, welcher beim Einschieben der Flachbaugruppe BG durch ein Mittel F1 zur elektrischen Kontaktierung des Schleifkontakts K mit dem Baugruppenträger BGT elektrisch leitend kontaktiert wird.

Erfindungsgemäß ist bei der Flachbaugruppe BG der Schleifkontakt K nicht direkt mit der Frontplatte FP elektrisch verbunden. Vielmehr ist eine Isolationsstrecke G zwischen Frontplatte FP und dem Schleifkontakt K vorhanden, welche über einen auswählbaren elektrischen Widerstand R überbrückt wird. Beispielsweise durch Berührkontakt einer Person auf die Frontplatte FP aufgebrachte elektrostatische Ladungen werden somit beim Einschieben der Flachbaugruppe BG nahezu ohne Verursachung von Störsignalen durch eine über den Widerstand gedämpfte Entladung an den in der Regel auf Erdpotential liegenden Baugruppenträger BGT abgeleitet. Vorteilhaft ist der Widerstand mit einem elektrisch leitenden Endstück ES verbunden, welches zur Befestigung der Frontplatte FP an der Leiterplatte LP dient.

Die Entladung beim Einschieben der Flachbaugruppe EG erfolgt im Baugruppenträger BGT über den Widerstand R, den Kontaktstreifen K und das Mittel F1 zur elektrischen Kontaktierung des Schleifkontakts K. Dieses weist insbesondere ein Kontaktfederelement F1 zur elektrischen Kontaktierung des Schleifkontakts K auf und kann beispielsweise im Bereich der Führungsschiene LS angebracht bzw. in diese integriert sein. Bereits zu Beginn des Einschiebens der Flachbaugruppe BG in den Baugruppenträger BGT wird der Schleifkontakt K, welcher in der Regel in Form einer Leiterbahn auf der Leiterplatte LP aufgebracht ist, durch das Kontaktfederelement F1 federnd umfaßt und kontaktiert.

Gemäß einer weiteren Ausführungsform des erfindungsgemäßen Baugruppenträgers BGT, weist dieser zumindest ein weiteres Mittel F2 zur elektrischen Kontaktierung des Schleifkontakts K mit dem Baugruppenträger BGT auf. Das Mittel F2 weist bevorzugt ein Kontaktfederelement F2 zur elektrischen Kontaktierung des Schleifkontakts K auf, welches bevorzugt im Bereich der Führungsschiene LS im hinteren Bereich im Innern des Baugruppenträgers BGT mit dem Baugruppenträger BGT elektrisch leitend verbunden ist und dem Kontaktfederelement F1 entspricht. Dadurch liegt erfindungsgemäß zumindest auch im hinteren Bereich im Innern des Baugruppenträgers BGT eine elektrisch leitende Verbindung zum streifenförmigen Schleifkontakt K vor, wenn die Flachbaugruppe BG in den Baugruppenträger BGT eingeschoben ist. Als hinterer Bereich ist der von der Frontplatte FP einer eingeschobenen Flachbaugruppe BG abgewandte Bereich des Baugruppenträgers BGT zu verstehen.

Die erfindungsgemäße zusätzliche Kontaktierung des Schleifkontakts K im hinteren Bereich des Baugruppenträgers BGT hat insbesondere den Vorteil, daß im eingeschobenen Zustand der Flachbaugruppe BG, wie in Figur 1b dargestellt ist, insbesondere von außen auf die Frontplatte aufgebrachte elektrostatische Ladungen über den streifenförmigen Schleifkontakt K nicht tief in den Baugruppenträger BGT eindringen können. Da der Schleifkontakt K durch die Kontaktfederelemente F1 und F2 zumindest beidseitig mit dem Baugruppenträger BGT kontaktiert ist, liegen vorteilhaft keine langen "antennenartigen" Bereiche des streifenförmigen Schleifkontakts K frei. Erfindungsgemäß werden somit mögliche hochfrequente "Ausstrahlungen" von Störsignalen über den Schleifkontakt K verhindert. Die Kontaktfederelemente F1 und F2 können insbesondere durch eine Verbindung mit einer vorderen und einer hinteren Querschiene QV bzw. QH des Baugruppenträgers BGT mit diesem elektrisch leitend verbunden sein.

In einer weiteren erfindungsgemäßen Ausführungsform des Baugruppenträgers BGT sind zusätzlich Mittel zur elektrisch leitenden Kontaktierung der Frontplatte FP mit dem Baugruppenträger BGT vorhanden. Diese sind in den Figuren durch das Bezugszeichen SR dargestellt und bevorzugt in Form einer Schraube ausgeführt. Diese Mittel werden dann wirksam, wenn die Frontplatte FP sich im eingesteckten Zustand befindet.

In Figur 2b ist der bereits in Figur 2a dargestellte Baugruppenträger BGT mit eingeschobener Flachbaugruppe BG und wenigstens einer die Frontplatte FP durchreichenden Schraube SR als Mittel zur elektrisch leitenden Kontaktierung der Frontplatte FP mit dem Baugruppenträger BGT dargestellt. Bevorzugt durchreichen die Frontplatte FP an gegenüberliegenden Enden (nicht dargestellt) jeweils wenigstens eine Schraube SR, mittels der die Flachbaugruppe BG im eingeschobenen Zustand mit dem Baugruppenträger BGT, insbesondere mit einer vorderen Querschiene QV, elektrisch kontaktierend verschraubbar ist. Erfindungsgemäß liegt somit eine weitere Kontaktierung der metallischen Frontplatte FP mit dem Baugruppenträger BGT vor. Dadurch wird bewirkt, daß im vollständig eingeschobenen Zustand von außen auf die Frontplatte FP aufgebrachte elektrostatische Ladungen vorteilhaft über die Schraube SR direkt auf den Baugruppenträger BGT entladbar sind und nicht über den Kontaktstreifen K in dessen Inneres gelangen. Ein derartiges, bevorzugt schraubenartiges Kontaktmittel SR bewirkt eine Überbrückung der Reihenschaltung von Widerstand R, Schleifkontakt K und den elektrischen Kontaktmitteln F1, F2 zum Baugruppenträger BGT.

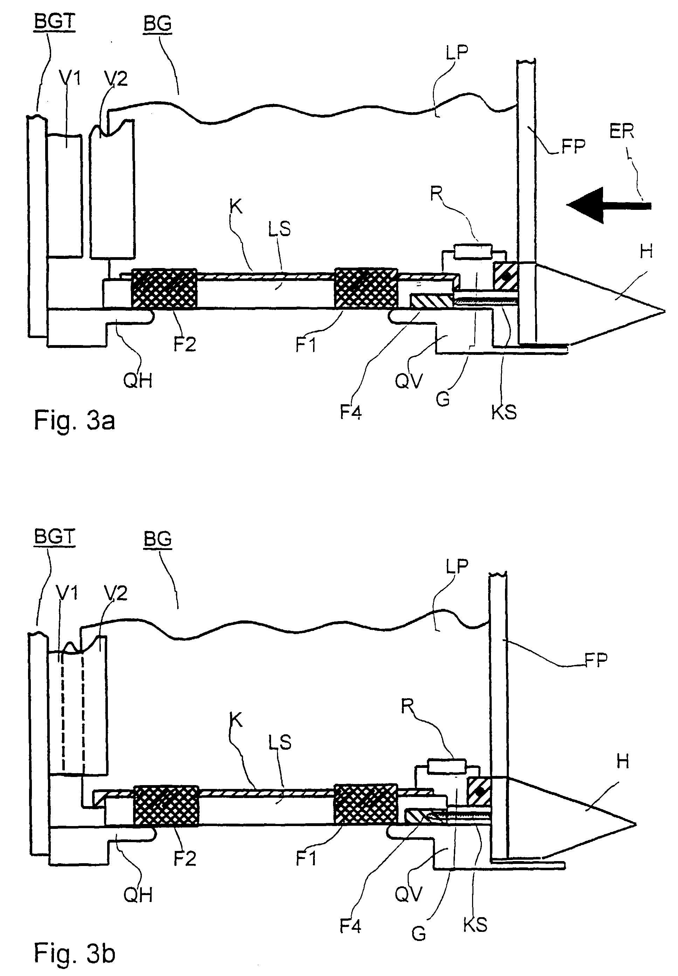

In Figur 3a ist eine weitere Ausführungsform des Baugruppenträgers BGT gemäß der Erfindung dargestellt, wobei die Frontplatte FP wenigstens einen zusätzlichen Kontaktstift KS aufweist. Dieser ist bevorzugt am unteren Ende der Frontplatte angebracht und zeigt in Einschubrichtung ER der Flachbaugruppe in das Innere des Baugruppenträgers. Der Kontaktstift KS kontaktiert während des Einsteckvorganges der Flachbaugruppe BG die Frontplatte FP direkt über ein weiteres Kontaktfederelement F4 elektrisch leitend mit dem Baugruppenträger BGT. Das Kontaktfederelement F4 ist bevorzugt leitend mit der unteren Querschiene QV verbunden.

Eine derartige erfindungsgemäße Ausführungsform ist besonders vorteilhaft bei Flachbaugruppen BG, welche nicht mit dem Baugruppenträger BGT verschraubbar, sondern beispielsweise mittels eines sogenannten Hebel-Ziehgriffs H am Baugruppenträger BGT verrastbar sind. Ist in einem solchen Fall sowohl der Kontaktstift KS als auch das Kontaktfederelement F4 ausreichend mechanisch stabil ausgeführt, so kann es mehrere Funktionen gleichzeitig erfüllen. Zum einen können Kontaktstift und Kontaktfeder eine mechanische Führung der Flachbaugruppe während des Einführvorganges bewirken, so daß ein seitliches Ausweichen vermieden werden kann. Ferner können beide Elemente im vollständig eingeschobenen Zustand der Flachbaugruppe als ein sogenannter Schutzkontakt dienen. Hiermit ist eine die VDE Anforderungen erfüllende Masseverbindung der Frontplatte möglich. Es kann dann auf eine zusätzliche Schraube SR, wie in den Figuren la und 1b gemäß Stand dem Technik dargestellt, verzichtet werden. Schließlich können beide Elemente auch eine derartige mechanische Verbindung zwischen Flachbaugruppe und Baugruppenträger bewirken, daß eine zusätzliche Schraube zur weiteren Fixierung nicht mehr notwendig ist.

Das Kontaktfederelement F4 ist dabei bevorzugt im vorderen Bereich des Baugruppenträgers BGT im Bereich der Führungsschiene LS angebracht und mit diesem elektrisch leitend verbunden. Das Kontaktfederelement F4 kann beispielsweise mit einer vorderen Querschiene QV des Baugruppenträgers BGT elektrisch leitend verbunden sein.

Beim Einschieben der Flachbaugruppe BG kontaktiert der Kontaktstift KS elektrisch leitend das Kontaktfederelement F4, bevor die Verbindung zwischen dem Steckverbinder V1 des Baugruppenträgers BGT und und dem Steckverbinder V2 der Leiterplatte LP der Flachbaugruppe BG erfolgt. Dadurch liegt neben dan Schleifkontakten eine weitere Möglichkeit vor, auf der Frontplatte FP befindliche elektrostatische Ladungen vorteilhaft über Kontaktstift KS und Kontaktfederelement F4 auf den Baugruppenträger BGT zu entladen, bevor die Inbetriebnahme der Baugruppe BG durch die Verbindung der Steckverbinder V1 und V2 erfolgt.

In Figur 3b ist der bereits in Figur 3a dargestellte Baugruppenträger BGT mit eingeschobener Flachbaugruppe BG dargestellt. Erfindungsgemäß wird bewirkt, daß im eingeschobenen Zustand der Flachbaugruppe BG insbesondere von außen auf die Frontplatte FP aufgebrachte elektrostatische Ladungen vorteilhaft über den Kontaktstift KS und das Kontaktfederelement F4 direkt auf den Baugruppenträger BGT entladbar sind und nicht über den Kontaktstreifen K in dessen Inneres gelangen.

Vorteil eines Baugruppenträgers gemäß der Erfindung ist insbesondere die Ein- bzw. Aussteckbarkeit einer Flachbaugruppe BG auch während des Betriebs der übrigen weiteren Flachbaugruppen im Baugruppenträger ohne eine dadurch verursachte Emission von Störsignalen, welche das korrekte Funktionieren der übrigen Flachbaugruppen im Baugruppenträger BGT beeinträchtigen könnte.

## Patentansprüche

1. Baugruppenträger (BGT), mit
a) mindestens einer elektrischen Flachbaugruppe (BG), welche in diesen einsteckbar ist, und eine metallische Frontplatte (FP) und eine Leiterplatte (LP) mit mindestens einem streifenförmigen Schleifkontakt (K) in den Randbereichen aufweist,
b) mit Kontaktmitteln (F1,F2) zur elektrischen Kontaktierung des streifenförmigen Schleifkontakts (K) der Flachbaugruppe (BG) mit dem Baugruppenträger (BGT), wobei zumindest ein solches Kontaktmittel (F1) im vorderen Bereich im Inneren des Baugruppenträgers (BGT) angeordnet ist, und mit
c) einem elektrischen Widerstand (R), der die Frontplatte (FP) der elektrischen Flachbaugruppe (BG) mit dem Schleifkontakt (K) elektrisch leitend verbindet.

2. Baugruppenträger (BGT) nach Anspruch 1, **dadurch gekennzeichnet**, daß die Kontaktmitteln (F1, F2) zur elektrischen Kontaktierung des Schleifkontakts (K) zumindest ein Kontaktfederelement (F1) aufweisen.

3. Baugruppenträger (BGT) nach Anspruch 2, **dadurch gekennzeichnet**, daß der Baugruppenträger (BGT) zur Halterung der elektrischen Flachbaugruppen (BG) mindestens eine Führungsschiene (LS) aufweist, und das mindestens eine Kontaktfederelement (F1) in einer Führungsschiene (LS) integriert ist.

4. Baugruppenträger (BGT) nach einem der vorangegangenen Ansprüche, **dadurch gekennzeichnet**, daß zumindest ein weiteres Kontaktmittel (F2) zur elektrischen Kontaktierung des Schleifkontakts (K) im hinteren Bereich im Innern des Baugruppenträgers (BGT) angeordnet ist.

5. Baugruppenträger (BGT) nach einem der vorangegangenen Ansprüche, mit zumindest einer Schraube (SR) zur elektrisch leitenden Verschraubung der Frontplatte (FP) mit dem Baugruppenträger (BGT) im vollständig eingeschobenen Zustand.

6. Baugruppenträger (BGT) nach Anspruch 1, **gekennzeichnet** durch wenigstens einen, an der Frontplatte (FP) elektrisch leitend angebrachten Kontaktstift (KS), welcher beim Einstecken der Flachbaugruppe (BG) in den Baugruppenträger (BGT) mit einem Kontaktfederelement (F4) elektrisch leitend kontaktiert wird.

## Claims

1. Mounting rack (BGT), having
a) at least one electrical printed circuit board assembly (BG) which can be plugged into this mounting rack (BGT), and has a metallic front panel (FP) and a printed circuit board (LP) having at least one strip sliding contact (K) in the edge regions,
b) having contact means (F1, F2) for making electrical contact between the strip sliding contact (K) of the printed circuit board assembly (BG) and the mounting rack (BGT), at least one such contact means (F1) being arranged in the front region in the interior of the mounting rack (BGT), and having
c) an electrical resistor (R) which electrically conductively connects the front panel (FP) of the electrical printed circuit board assembly (BG) to the sliding contact (K).

2. Mounting rack (BGT) according to Claim 1, characterized in that the contact means (F1, F2) have at least one contact spring element (F1) in order to make electrical contact with the sliding contact (K).

3. Mounting rack (BGT) according to Claim 2, characterized in that the mounting rack (BGT) has at least one guide rail (LS) in order to hold the electrical printed circuit board assemblies (BG), and the at least one contact spring element (F1) is integrated in a guide rail (LS).

4. Mounting rack (BGT) according to one of the preceding claims, characterized in that at least one further contact means (F2) for making electrical contact with the sliding contact (K) is arranged in the rear region in the interior of the mounting rack (BGT).

5. Mounting rack (BGT) according to one of the preceding claims, having at least one screw (SR) for electrically conductive screw connection of the front panel (FP) to the mounting rack (BGT) in the completely inserted state.

6. Mounting rack (BGT) according to Claim 1, characterized by at least one contact pin (KS) which is electrically conductively fitted on the front panel (FP) and makes electrically conductive contact with a contact spring element (F4) during insertion of the printed circuit board assembly (BG) into the mounting rack (BGT).

## Revendications

1. Support de modules (BGT) comprenant
a) au moins un module électrique plat (BG), qui peut y être enfiché, et qui présente une plaque frontale (FP) métallique et une plaque de circuit imprimé (LP) comportant, dans les zones de bordure, au moins un contact frottant (K) en forme de bande,
b) comprenant également des moyens de contact (F1, F2) pour l'établissement du contact électrique entre le contact frottant (K) en forme de bande du module plat (BG) et le support de modules (BGT), au moins un tel moyen de contact (F1) étant disposé dans la zone avant à l'intérieur du support de modules (BGT), et comprenant en outre
c) une résistance électrique (R) qui réalise une liaison conductrice du point de vue électrique de la plaque frontale (FP) du module plat (BG) électrique au contact frottant (K).

2. Support de modules (BGT) selon la revendication 1, **caractérisé** en ce que les moyens de contact (F1, F2) pour établir le contact électrique avec le contact frottant (K) comportent au moins un élément de contact élastique (F1).

3. Support de modules (BGT) selon la revendication 2, **caractérisé** en ce que le support de modules (BGT) comprend, pour le maintien des modules plats (BG) électriques, au moins un rail de guidage (LS), et ledit au moins un élément de contact élastique (F1) est intégré dans un rail de guidage (LS).

4. Support de modules (BGT) selon l'une des revendications précédentes, **caractérisé** en ce qu'au moins un autre moyen de contact (F2) pour l'établissement d'un contact électrique avec le contact frottant (K) est disposé dans la zone arrière, à l'intérieur du support de modules (BGT).

5. Support de modules (BGT) selon l'une des revendications précédentes, comprenant au moins une vis (SR) destinée à réaliser une liaison vissée conductrice du point de vue électrique, de la plaque frontale (FP) au support de modules (BGT), dans l'état totalement inséré.

6. Support de modules (BGT) selon la revendication 1, **caractérisé** par au moins une broche de contact (KS) placée sur la plaque frontale (FP) de manière conductrice du point de vue électrique, et qui lorsque l'on enfiche le module plat (BG) dans le support de modules (BGT), établit un contact conducteur sur le plan électrique avec un élément de contact élastique (F4).
